# EUROPEAN PATENT SPECIFICATION

(11) **EP 3 435 192 B1**
(45) Date of publication and mention of the grant of the patent: **24.08.2022**
(21) Application number: 17306018.7
(22) Date of filing: 28.07.2017
(51) Int. Cl.: G05F 1/575, G05F 1/56

(54) **ULTRA LOW POWER LINEAR VOLTAGE REGULATOR**
LINEARER SPANNUNGSREGLER MIT EXTREM NIEDRIGEM STROM
PUISSANCE ULTRA FAIBLE RÉGULATEUR DE TENSION LINÉAIRE

(43) Date of publication of application: 30.01.2019
(73) Proprietor: NXP USA, Inc., Austin TX 78735 (US)
(72) Inventor: ENJALBERT, Jerome Romain, 31023 Toulouse cedex 1 (FR); MALEYRAN, Marianne, 31023 Toulouse cedex 1 (FR); LANCE, Philippe Bernard Roland, 31023 Toulouse cedex 1 (FR); OUADDAH, Jalal, 31023 Toulouse cedex 01 (FR)
(74) Representative: Hardingham, Christopher Mark

(56) References cited:
- US-A1- 2005 134 242
- US-A1- 2014 103 890
- US-A1- 2016 103 458
- US-B1- 6 177 785
- US-B1- 7 880 452
- YONGTAE KIM ET AL: "An ultra-low voltage digitally controlled low-dropout regulator with digital background calibration", QUALITY ELECTRONIC DESIGN (ISQED), 2012 13TH INTERNATIONAL SYMPOSIUM ON, IEEE, 19 March 2012 (2012-03-19), pages 151-158, XP032169354, DOI: 10.1109/ISQED.2012.6187488 ISBN: 978-1-4673-1034-5

## Description

### FIELD

This disclosure relates generally to linear voltage regulation, and more specifically to voltage regulation requiring ultra low quiescent power consumption.

### BACKGROUND

Consumer sensing applications are often required to perform highly accurate measurements for a relatively short period of time relative to the total time the sensor is activated. High accuracy measurements are often achieved with analog circuitry having large bias currents that will dominate quiescent current consumption between MEASUREMENT phases. Consumer sensors with digital outputs offer a programmable data rate to provide the best trade-off between performance, (e.g. noise in particular) and current consumption.

A common use case includes configuring an accelerometer to operate at a low data rate to monitor motion in the application, with very low power consumption. When motion is detected, the microcontroller changes the configuration of the sensor to operate at a higher data rate to get a series of high accuracy, low noise measurements of the acceleration.

To offer a wide range of Output Data Rates (ODRs), consumer accelerometers employ pulsed operation. For example, low-noise signal acquisition and conversion is performed during a MEASUREMENT phase with relatively high current consumption (IDD). The MEASUREMENT phase has a fixed duration and repeats at a frequency equal to the ODR. Between two consecutive MEASUREMENT phases is an IDLE phase with the duration dependent on the ODR. The current consumption during the IDLE phase is reduced to the minimum to operate as a voltage regulator to supply power to the digital block of the accelerometer and to keep a user-programmed register content and a low-frequency oscillator operational to control the length of this IDLE phase.

For instance, US 6 177 785 B1 discloses a voltage regulator, which includes a programmable reference generator, a programmable output adjustor, an error amplifier, and an output driver. The programmable reference generator is responsive to a first programming signal and generates a reference voltage. The programmable output adjustor is responsive to a second programming signal and generates an output adjust voltage. The error amplifier generates an error voltage corresponding to a difference between the reference voltage and the output adjust voltage. The output driver drives a regulated output voltage in response to the error voltage. A capacitor is coupled between the regulated output voltage and a ground voltage to eliminate ripple components on the regulated voltage.

### BRIEF DESCRIPTION OF THE DRAWINGS

The present invention is illustrated by way of example and is not limited by the accompanying figures, in which like references indicate similar elements. Elements in the figures are illustrated for simplicity and clarity and have not necessarily been drawn to scale.
FIG. 1 is a functional block diagram of a system for ultra low power linear voltage regulation in accordance with an embodiment of the present disclosure.
FIG. 2 is a schematic view of an embodiment of an ultra low power linear voltage regulator included in FIG. 1
FIG. 3 is a schematic view of an embodiment of a Power On Reset (POR) circuit, and digital circuit included in FIG. 1.
FIG. 4 is a flowchart representation of a method for a START-UP phase of an ultra low power linear voltage regulator.
FIG. 5 is a flowchart representation of a method for an IDLE phase of an ultra low power linear voltage regulator.
FIG. 6 is a flowchart representation of a method for a MEASURMENT phase of an ultra low power linear voltage regulator.
FIG. 7 is a graphical view of a timing diagram for an embodiment of an ultra low power linear voltage regulator.

### DETAILED DESCRIPTION

Embodiments of systems and methods described herein provide for ultra low power voltage regulation by deactivating direct current (DC) paths and analog circuitry of a linear voltage regulator during an IDLE phase. The IDLE phase is defined as the time between MEASUREMENT phases, wherein higher current consumption is necessitated for improved measurement results. In one example, during the MEASUREMENT phase, current consumption increases relative to the IDLE phase by activating resistive strings and current biased amplifiers. In this example, during the IDLE phase a digital circuit is kept active to retain user-programmed content and a low-frequency oscillator controls the duration of the IDLE phase. The embodiments are further extended to ensure low voltage dropout operation with active pull-up devices.

Paradoxically, the linear voltage regulator, including the power consuming DC paths and amplifiers, supplies power to the digital circuitry, and the digital circuitry provides control signals to the linear voltage regulator to assist with the transition between the IDLE and MEASUREMENT phases through preservation of states and an efficient Power On Reset (POR). By allowing for interdependency between the linear voltage regulator and the digital circuitry and providing innovative solutions to starting-up the system of digital and analog circuitry and transitioning between the IDLE and MEASUREMENT phases, exceptionally low quiescent power and total power consumption is realized.

At very low Output Data Rates (ODRs), for example as used for basic motion detection (e.g., 1Hz) in a sensor system, the contribution of the MEASUREMENT phase to the total average current consumption (IDD) becomes negligible due to the low duty cycle, (defined as the MEASUREMENT phase divided by the total cycle time of MEASUREMENT plus IDLE phases). The ODR (and hence the duty cycle) is also limited by the rate of variation of the supply voltage during the IDLE phase. For example, VDD cannot be allowed to vary excessively during the IDLE phase, when an external voltage used by the digital circuits is unregulated and when the external voltage is clamped to VDD by pull-up circuits. As used herein, the term "external voltage" refers to a voltage that is outside of a regulated feedback loop of the power converter, but not necessarily outside of an Integrated Circuit (IC) that includes the power converter. The external voltage is derived from a regulated "internal voltage" by use of a common gate voltage as further described below. In one embodiment, a variation of VDD was found to be less than +/- 200mV in 25ms, hence a duty cycle of 1/100 was practical. In example embodiments with low ODRs, test results have shown a reduction in total average current consumption from 1uA down to 10nA - a reduction of 100X compared to previous products. Similar results are envisioned for other product applications targeting ultra low power, including without limitation Internet of Things (IoT) and sensor based applications.

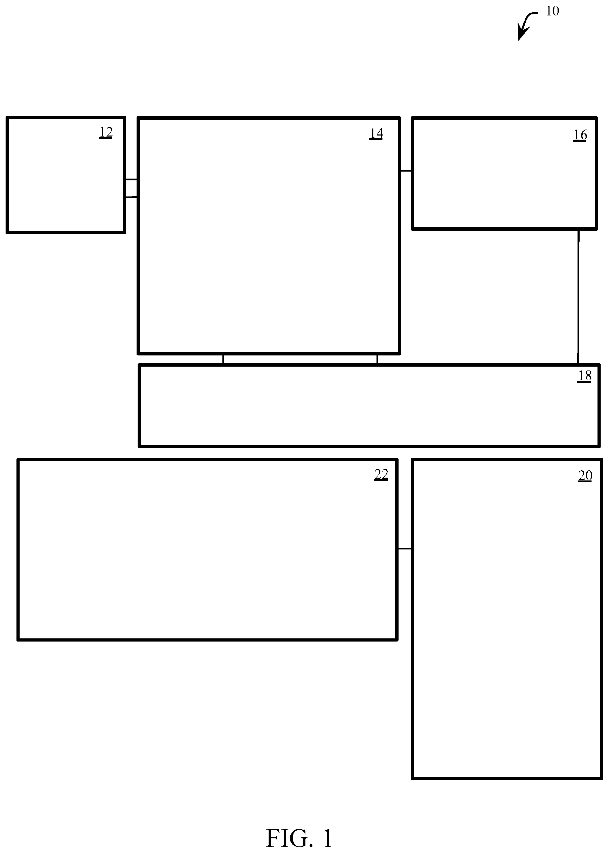

FIG. 1 shows the functional blocks of an embodiment of a system 10 including an ultra low power linear voltage regulator ("voltage regulator") and a digital circuit. The voltage regulator includes a bandgap reference 12, a feedback loop 14, an external voltage circuit 16 and a pull-up circuit 18. The bandgap reference 12 provides a temperature stabilized reference voltage to the feedback loop 14. The feedback loop 14 regulates an internal voltage to a multiple of the reference voltage by using an amplifier configured with negative feedback. The external voltage circuit 16 creates an external voltage to "mirror" or be substantially equal to the internal voltage. The pull-up circuit 18 ensures that the internal voltage and the external voltage will each be clamped to the supply voltage (VDD), when VDD drops to a level marginally above the reference voltage such that effective voltage regulation is no longer possible. In one example a difference between VDD and the reference voltage must exceed a gate-to-source voltage drop (Vgs) of an N-channel Field Effect Transistor (FET) or NFET for the feedback loop 14 to function properly.

The system 10 further includes a power on reset (POR) circuit 22 and a digital circuit 20. The POR circuit includes an imprecise POR that forces a reset of the digital circuit 20 when VDD is first applied and thereby also forces active-low enable signals from the digital circuit 20 to activate the bandgap reference 12, which in turn activates the feedback loop 14 to generate a stable internal voltage. A stable bandgap condition also activates a more precise POR, which keeps the digital circuit 20 in the reset state until the internal voltage is stable.

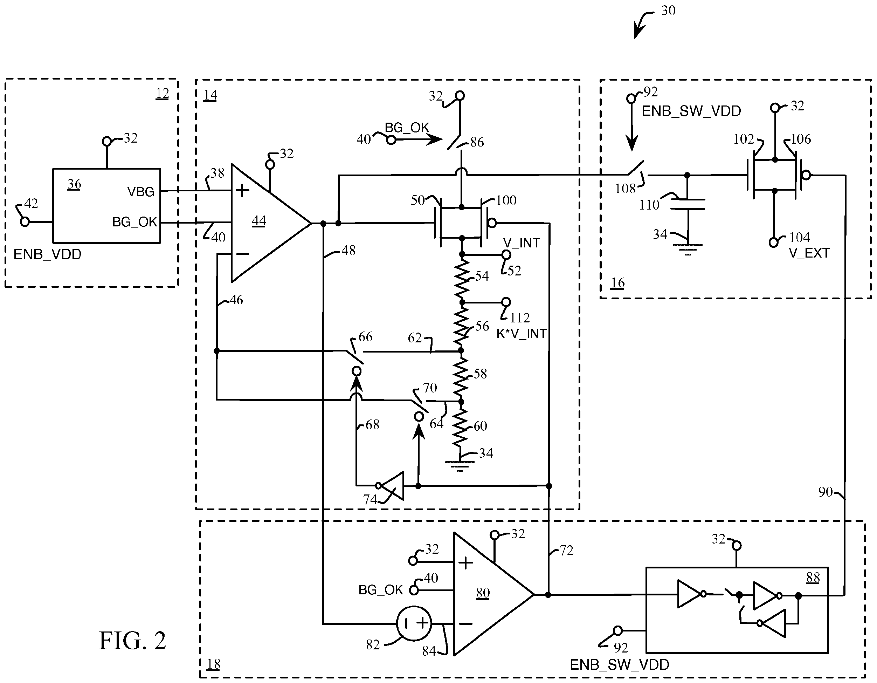

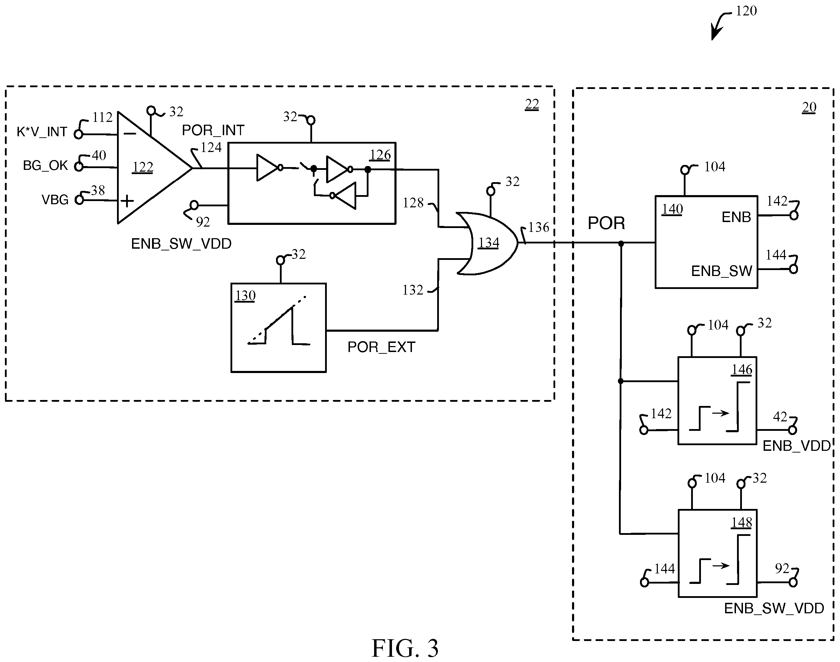

Turning to FIG. 2 with on-going reference to FIG. 1, the voltage regulator is now described in further detail. In FIG. 2 and FIG.3, various embodiments of the circuits that are supplied by VDD 32 and/or an external voltage 104 are referenced to VSS 34, however the connections to VSS 34 are not shown for clarity of exposition. An embodiment of a voltage regulator 30 includes a bandgap reference 12, a feedback loop 14, an external voltage circuit 16 and a pull-up circuit 18. The pull-up circuit 18 controls PFETs 100 and 106 in the feed-back loop 14 and external voltage circuit 16 respectively. The bandgap reference 12 receives power from the supply voltage (VDD) 32, which is further referenced to ground (VSS) 34. In one embodiment, the ground 34 is at zero volts, although in other embodiments other DC voltage references are used for ground 34. In one embodiment, the bandgap reference 12 includes a bandgap with a Current Proportional To Absolute Temperature (IPTAT) circuit 36. The bandgap with IPTAT circuit 36 (generally the bandgap reference 12) is enabled with an active-low ENB_VDD signal 42 to produce a reference voltage (VBG) 38. When the reference voltage is stable, the bandgap reference 12 activates a bandgap status signal (BG_OK) 40.

The feedback loop 14 includes an amplifier 44 powered by VDD 32. The amplifier 44 is enabled by the BG_OK 40 and compares the reference voltage 38 to a feedback signal 46 to produce a control voltage 48. In one embodiment, the amplifier 44 is an Operational Transconductance Amplifier (OTA). The control voltage 48 drives the gate of an internal voltage NFET 50 to generate an internal voltage 52. The NFET 50 is arranged as a source follower to generate the internal voltage 52 at the source of the NFET 50. The NFET 50 is connected in series with a resistor string, (e.g., resistive divider), formed by resistors 54, 56, 58 and 60, and ground 34. The resistor string provides a high tap 62 connected between resistors 56 and 58. The resistor string provides a low tap 64 connected between resistors 58 and 60. The high tap 62 and the low tap 64 are connected to the feedback signal 46 by a P-channel FET (PFET) switch 66 controlled by signal 68 and by a PFET switch 70 controlled by a pull-up signal 72 respectively. Inverting the pull-up signal 72 with an inverter 74 generates the signal 68. The high tap 62 and low tap 64 are designed to provide hysteresis to the amplifier 44 controlled by the pull-up signal 72. In another embodiment, the switches 66 and 70 are NFET switches, the pull-up signal 72 controls the switch 66 and the inverted signal 68 controls the switch 70.

The pull-up circuit 18 includes a pull-up comparator 80, powered by VDD 32, enabled by the BG_OK 40, and configured to compare VDD 32 with an offset control voltage 84. Adding an offset voltage 82 to the control voltage 48 generates the offset control voltage 84. In one non-limiting embodiment, the offset voltage 82 is a charged capacitive element (e.g., a battery or capacitor charged with switches). In one example, the offset voltage 82 is a few dozen mV. The pull-up signal 72 transitions low (e.g. active) when VDD 32 decreases to within an offset voltage (or less) of the control voltage 48. The control voltage 48 is equal to the internal voltage 52 plus the Vgs drop of the internal voltage NFET 50. When the pull-up signal 72 transitions low, the PFET switch 70 connects the low tap 64 to the feedback signal 46, thereby increasing the control voltage 48 to ensure a clean transition of the pull-up signal 72 without oscillations. Conversely, when the pull-up signal 72 transitions high, the PFET switch 66 connects the high tap 62 to the feedback signal 46 to lower the control voltage 48.

The bandgap reference 12 is disabled with the ENB_VDD 42 signal, which disables the BG_OK signal 40. The BG_OK signal subsequently disables the amplifier 44, the pull-up comparator 80 and the switch 86. The switch 86 disables the DC path flowing from VDD 32, through the internal voltage NFET 50, through the resistors 54, 56, 58, 60, and to the ground 34.

The pull-up circuit further includes a pull-up latch 88 powered by VDD 32. The pull-up latch 88 generates a latched pull-up signal 90 from the pull-up signal 72 in response to the active-low ENB_SW_VDD signal 92. Specifically, the pull-latch 88 allows the pull-up signal 72 to flow through the latch when the ENB_SW_VDD signal 92 is low ("0"), and latches the pull-up signal 72 when signal 92 is high ("1"). When the pull-up signal 72 is active due to an insufficient voltage (e.g., headroom) between VDD 32 and the control voltage 48, the pull-up signal 72 activates the internal voltage PFET 100, thus clamping the internal voltage 52 to VDD 32.

The external voltage circuit 16 includes an external voltage NFET 102 connected between VDD 32 and a generated external voltage 104. Similar to the internal voltage NFET 50, the external voltage NFET 102 is configured as a source follower. An external voltage PFET 106 is connected in parallel with the external voltage NFET 102 and is configured to clamp the external voltage 104 to VDD 32 in response to the latched pull-up signal 90 being active (e.g., low or "0"). The latched pull-up signal 90 will activate the external voltage PFET when low regardless of whether the pull-up latch is open (e.g., in flow-through mode) or closed (e.g. latched). The ENB_SW_VDD signal 92 also activates a switch 108 to store the control voltage 48 on a storage capacitor 110 connected to ground 34. Specifically, when the ENB_SW_VDD signal 92 is low ("0"), the control voltage 48 is connected directly to the gate of the external voltage NFET 102. When the ENB_SW_VDD signal 92 is high ("1"), the switch 108 is opened and the gate voltage for the external voltage NFET 102 is held on the storage capacitor 110.

In various embodiments, the system 10 of FIG. 1 is implemented in an MOS technology including without limitation, CMOS, DMOS or BICMOS. Regardless of the chosen technology, it is important for the external voltage NFET to be implemented in an MOS technology to reduce leakage on the storage capacitor 110. The voltage regulator 30 is very stable because the feedback loop 14, which generates the internal voltage 52 has a relatively small and constant capacitive load. In various embodiments, the current densities of the internal voltage NFET 50 and the external voltage NFET 102 are matched to ensure good matching between the internal voltage 52 and the external voltage 104. In embodiments where the current densities have a small amount of mismatch, differences between the internal voltage 52 and the external voltage 104 are small because the internal voltage NFET 50 and the external voltage NFET 102 operate in weak inversion. It should be noted that the external voltage circuit 16 is external to the feedback loop 14, but may or may not be external to the Integrated Circuit (IC) that contains the feedback loop 14. Furthermore, certain embodiments include more than one external voltage circuit 16 with either a corresponding pull-up circuit 18 or a shared connection to the latched pull-up signal 90. In various embodiments, the feedback loop 14 also includes a scaled internal voltage 112 as shown in FIG. 2 between resistors 54 and 56. It should be understood that the embodiment of FIG. 2 is not limited to the four resistors 54, 56, 58 and 60, as different numbers of resistors are realizable to implement the hysteresis for the amplifier 44 and to provide for the scaled voltage 112.

FIG. 3, with continued reference to FIG. 1 and FIG. 2, describes an embodiment 120 of a POR circuit 22 and a digital circuit 20. The POR 22 includes a POR comparator 122, powered by VDD 32 and enabled by BG_OK 40. The POR comparator 122 is configured to compare the scaled voltage 112 with the reference voltage 38 to generate an internal POR (POR_INT) signal 124. The ratio of the scaled voltage 112 to the internal voltage 52 is designed to ensure that POR_INT is activated in the presence of manufacturing and environmental (e.g., voltage and temperature) variations. For example, due to standard manufacturing and environmental variations, the regulated internal voltage 52, which is regulated to a multiple of the reference voltage 38, may vary.

The POR_INT 124 is latched by a POR latch 126 to generate a latched POR_INT 128, in response to the ENB_SW_VDD signal 92 transitioning high ("1"). Similarly, the latched POR_INT 128 tracks the POR_INT signal 124 when the latch 126 is open, in response to the ENB_SW_VDD signal 92 transitioning low ("0"). The POR latch 126 is powered by VDD 32. The POR circuit 22 further includes an imprecise POR 130 powered by VDD 32. The imprecise POR 130 generates an external POR (POR_EXT) signal 132 proportional to a value of VDD 32 while VDD 32 is ramped up to a start-up threshold. The start-up threshold is sufficient to ensure that the bandgap reference 12 starts up and has a stable BG_OK 40 with the available VDD 32 voltage. The latched POR-INT 128 and the POR_EXT signal 132 are combined with a Boolean OR gate 134 to generate a POR signal 136. The OR gate 134 is powered by VDD 32.

An embodiment of the digital circuit 20 includes a controller 140, powered by the external voltage 104 from the voltage regulator, and is configured to generate timing signals to control the voltage regulator. It should be understood that in various embodiments, the digital circuit 20 contains more than just the circuitry required to control the voltage regulator. For example, the digital circuit may contain logic functions such as a Serial Port Interface (SPI), I2C communication functions, state machines, and various algorithmic circuits. In some embodiments, the digital circuit includes 10,000 or more logic gates or up to multiple millions of gates. Specifically, the controller 140 generates at least an active-enable signal (ENB) 142 and an active-low enable switch signal (ENB_SW) 144, both of which transition between a ground 34 voltage and the external voltage 104. The controller 140 is connected to the POR 136 signal for resetting the controller 140. In one embodiment, the digital circuit also includes an ENB level shifter 146, and an ENB_SW level shifter 148. In another embodiment, the ENB level shifter 146 and the ENB_SW level shifter 148 are separate circuits from the digital circuit 20 with similar connections as shown in FIG. 3.

The ENB level shifter 146 is powered by both the external voltage 104 and VDD 32 and is reset with the POR signal 136. The ENB level shifter 146 shifts the ENB signal 142 to generate the ENB_VDD signal 42, which transitions between a ground 34 voltage and VDD 32. The ENB_SW level shifter 148 is powered by both the external voltage 104 and VDD 32 and is reset with the POR signal 136. The ENB_SW level shifter 148 shifts the ENB_SW signal 144 to generate the ENB_SW_VDD signal 92, which transitions between ground 34 voltage and VDD 32.

The external (e.g. imprecise) POR signal 132 is generated from VDD 32 and hence ensures that the enable signal ENB_VDD 42 for the bandgap reference 12 of the voltage regulator is correctly asserted on start-up, when input voltage VDD ramps from ground potential (e.g., 0 Volts) and the external voltage 104 is also at ground potential. The level-shifters are configured to output a logic LOW value when the POR input 136 is HIGH. When VDD 32 is ramping but still too low for the analog blocks and/or the latches to operate correctly, the external POR 132 forces the POR input of the level-shifters to be HIGH, which results in the control signals ENB_VDD and ENB_SW_VDD being correctly asserted LOW for a safe start-up of the analog blocks. The POR circuit 22 also features a second Power-On-Reset signal POR_INT 124 generated from a scaled internally regulated voltage K^{∗}V_INT 112. This second POR needs to be precise and accurate for the following reasons.

In various embodiments, the boot sequence of the system 10 involves loading the contents of an embedded memory (e.g., a One Time Programmable memory) into registers to be used by the digital circuit 20 (or conversely, are part of the digital circuit). This boot sequence must be performed under a minimum value of the external voltage 104 supply, which powers the digital circuit 20 and also the embedded memory (not shown). Accordingly, the POR 136 must hold the digital circuit 20 in the reset state until the minimum value of the external voltage 104 is reached by the voltage regulator, to be able to reliably read the contents of the embedded memory.

Conversely, the nominal value of the external voltage 104 is just a bit lower than the minimum value of VDD 32 (e.g., 100mV lower in one example). Consequently, the detection window to generate POR_INT 124 is very narrow. On the one hand, if the POR 136 release voltage is set too low, the memory contents may not be read correctly. On the other hand, if the POR 136 release voltage is set too high, it may never be released in the case where VDD 32 is at its minimum value. To meet such accuracy constraints, the POR comparator 122 detects when the voltage at K^{∗}V_INT 112 crosses the reference voltage 38. Comparing a tap of the resistor divider of the feedback loop to the bandgap reference produces a precise POR threshold at minimum current consumption.

During the IDLE phase, if an unexpected event results in a significant drop in the VDD 32 level, (such as a glitch or line brown-out), the internal POR 124 activates to reset the system 10. This is needed because the latched POR_INT signal 128 depends upon the state of the latch 126, which will become indeterminate due to the unknown state of the ENB_SW_VDD signal 92 when there is an under-voltage event on VDD 32. In response to the under-voltage event, the external POR 132 forces the level shifters into a known state, which in turn resets the bandgap reference 12, which activates and stabilizes the feedback loop 14, and thereby generates the precise POR_INT 124 signal.

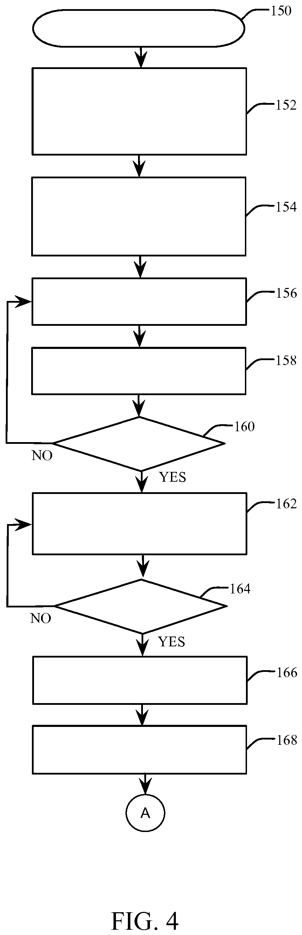

The operation sequence for the START-UP, MEASUREMENT and IDLE phases of the system 10 are shown in FIG. 4 to FIG. 6. Referring to FIG. 4, with continued reference to FIG. 2 and FIG. 3, the START-UP phase begins at 150 with VDD 32 at 0 Volts. At 152, the VDD voltage 32 ramps up from 0V towards an intended operating voltage. The POR_EXT is asserted (POR_EXT=1), with a voltage proportional to VDD 32. The POR_INT 124 signal remains indeterminate because the BG-OK signal 40 is indeterminate due to the low value of VDD 32. When VDD 32 is high enough for BG-OK 40 to be correctly asserted by the bandgap reference 12, the POR_INT signal 124, (and hence the latched POR_INT 128), will transition high. The POR signal 136 is active ("1") because the latched POR_INT 128 and POR_EXT 132 are combined with the OR gate 134. At 154, the POR signal 136 initializes (e.g. resets) the ENB level shifter 146 to generate the active-low ENB_VDD signal 42 at 0V, and the ENB_SW level shifter 148 to generate the active- low ENB_SW_VDD signal 92 at 0V.

At 156, the bandgap is started because the active-low ENB_VDD signal 42 is applied to the bandgap reference 12. At 156, the sample and hold is closed by activating switch 108 with the ENB_SW_VDD signal 92, thereby connecting the control voltage 48 directly to the gate of the external voltage NFET 102. At 158 the internal POR 124 is high ("1") because the POR comparator 122 is disabled (e.g., BG_OK is low). At 160, if the bandgap reference 12 has not stabilized, as indicated by BG_OK 40 being high ("1"), then the flow returns to 156. Otherwise at 162, when BG_OK is high, the BG OK signal 40 enables the amplifier 44 and the resistor string via the switch 86. The POR comparator 122 and the pull-up comparator 80 are also enabled by the BG_OK signal 40. At 164, if the interval voltage 52, and thus the scaled internal voltage K^{∗}V_INT 112, is stable and at the regulated voltage, then K^{∗}V_INT 112 will be at a higher voltage than VBG 38 and the POR comparator 122 will transition low (e.g., POR_INT =0). Otherwise the flow returns to 162. At 166, the POR 136 will transition low ("0") and thus at 168 the digital circuit 20, including the controller 140, ENB level shifter 146 and ENB_SW level shifter 148 will exit the rest mode.

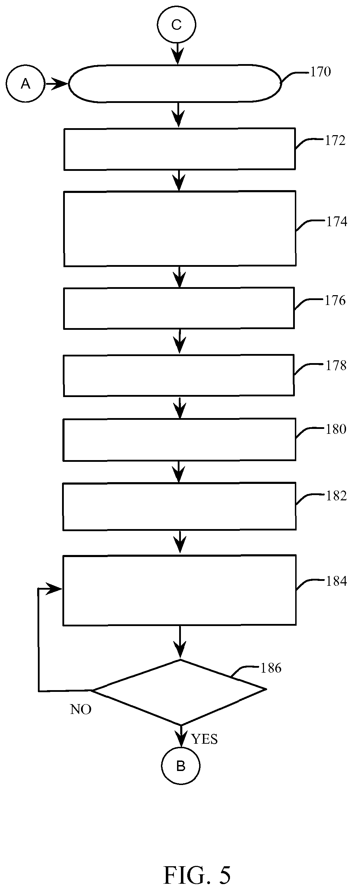

The POR_EXT 132 remains asserted until it reaches a predetermined "start-up threshold" designed to be sufficient for a correct operation of the bandgap reference 12. The POR remains asserted until the feedback loop 14 is stable because the POR_INT 124 activates before the POR_EXT 132 deactivates. Thus, the POR signal 136 transitions from the imprecise POR_EXT 132 to the relatively precise POR_INT 124. During startup, the active-low ENB_SWVDD signal 92 is low, hence the latched POR_INT 128 is equivalent to the POR_INT 124. After 168, the flow continues to 170 on FIG. 5.

Referring to FIG. 5, with continued reference to FIG. 2, FIG. 3 and FIG. 4, the IDLE phase begins at 170. At 172, the active-low ENB_SW_VDD signal 92 is deactivated ("1"). Consequently at 174, the sample-and-hold is opened, by opening the switch 108 with the ENB_SW_VDD signal 92, and thereby stores the control voltage 48 on the storage capacitor 110. The pull-up signal 72 is latched by the pull-up latch 88 to generate the latched pull-up signal 90. The POR_INT signal 124 is latched by the POR latch 126 to generate the latched POR-INT signal 128. Consequently, the external voltage 104 continues to power the digital circuit 20 however without a closed loop regulation. The last state of the pull-up signal 72 is maintained and the latched POR_INT 128 is held low ("0").

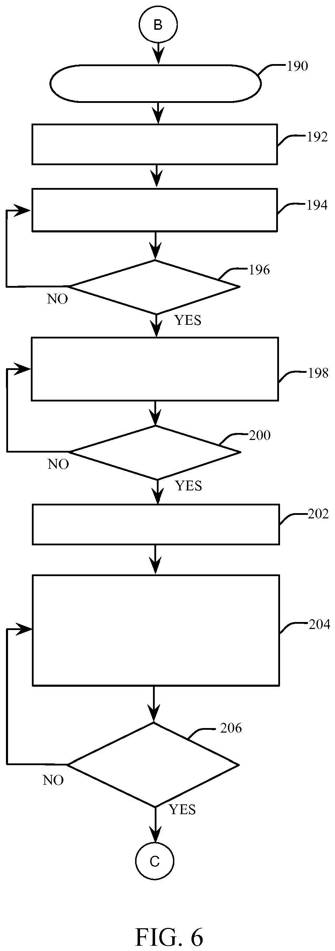

At 176, the ENB_VDD signal 42 is deactivated ("1"), which disables the bandgap reference 12 at 178. Disabling the bandgap reference 12 results in the BG_OK signal 40 transitioning low, or false ("0") at 180. At 182, the POR_INT 124 switches high ("1") because the POR comparator 122 is deactivated by the BG_OK signal 40 being low. The POR signal 136 remains low because the POR latch 126 held the last state of the POR_INT signal 124 before deactivating the POR comparator 122. At 184, the loopback amplifier 122, the POR comparator 122 and the pull-up comparator 80 are disabled in response to the BG_OK 40 being low. At 186, if the IDLE duration has elapsed, then the flow proceeds to 190 on FIG. 6. Otherwise, the flow returns to 184. The IDLE duration is determined in part due to the leakage on the storage capacitor 110 and gate of the external voltage NFET 102, and the variation of VDD 32 during this unregulated period.

Referring to FIG. 6, with continued reference to FIG. 2, FIG. 3 and FIG. 5, the MEASUREMENT phase begins at 190. At 192, the ENB VDD signal 42 is activated ("0"), which enables the bandgap reference 12 at 194. At 196, if the bandgap is stable as indicated by BG_OK 40 being high, then the flow proceeds to 198, otherwise the flow returns to 194. At 198, the feedback loop is enabled by enabling the amplifier 44, and the resistor string via the switch 86. The POR comparator 122, and the pull-up comparator 80 are also enabled by the BG_OK signal 40. In another embodiment, a combination of one or more of the amplifier 44, the resistor string via the switch 86, the POR comparator 122, and the pull-up comparator 80 are enabled at 198, and correspondingly disabled at 184 of FIG. 5.

At 200, if the POR_INT signal 124 is low ("0") as a result of the internal voltage 52 stabilizing (e.g., reaching a final regulated voltage similar to a multiple of the reference voltage 38), and consequently the scaled internal voltage 112 is stable, then the flow proceeds to 202, otherwise to 198. At 202, the active-low ENB_SW_VDD signal 92 is activated ("0"). At 204, the sample-and-hold is closed by closing the switch 108 and thereby "refreshing" the gate voltage on the external voltage NFET 102 by connecting the gate of the NFET 102 directly to the control voltage 48. The POR latch 126 is opened to allow the POR_INT 124 to flow through the latch 126. Similarly, the pull-up latch 88 is opened to allow the pull-up signal 72 to flow through the latch 88. At 206, if the MEASUREMENT duration has elapsed, the flow returns to 170 of FIG. 5 to enter the IDLE phase. Otherwise the flow returns to 204.

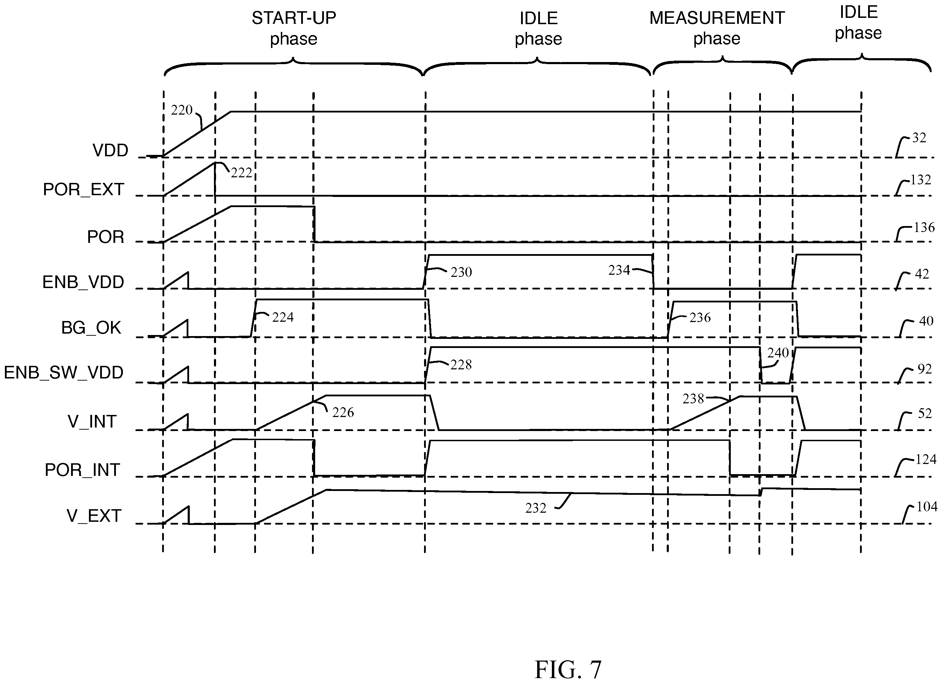

FIG. 7 is a graphical view of the timing for the START-UP, MEASUREMENT and IDLE phases as shown in FIG. 4, FIG. 5 and FIG. 6 respectively. The START-UP phase begins with VDD 32 at 0V and ramping to a final value as shown at 220. The POR_EXT 132 ramps in proportion to VDD 32 up to the start-up threshold shown at 222. The POR 136 activates the active-low ENB_VDD 42, which activates the bandgap reference 12. Once the bandgap reference 12 produces a stable reference voltage 38, the BG OK 40 is activated as shown at 224. The activated BG OK 40 enables the feedback loop 14, which ultimately produces a stable internal voltage 52, shown at 226. This stable voltage at 226 deactivates the internal POR 124. The analog state of the external voltage NFET 102, the digital state of the pull-up signal 72 and the digital state of the internal POR 124 are stored (by sampling and latching) by the ENB_SW _VDD signal 92 shown at 228. Entering the IDLE phase and powering down devices is accomplished by deactivating the ENB_VDD 42 shown as 230.

During the IDLE phase the digital circuit 20 continues to be powered by the external voltage 104 in an unregulated manner. As such, the V_EXT 104 slowly degrades over time as shown at 232. The MEASUREMENT phase is entered by activating the active-low ENB_VDD 42 as shown at 234. Similar to the START-UP phase, the ENB_VDD 42 activates the bandgap reference 12 to produce a stable reference voltage 38 as indicated by BG_OK 40 shown at 236. The activated bandgap reference 12 activates the feedback loop 14 and ultimately produces a stable internal voltage 52 shown at 238, which then disables the POR_INT 124. Once the voltage regulator has stabilized between 234 and 240, the preserved analog and digital states required to maintain the V_EXT 104 during the IDLE phase are refreshed, shown at 240. Specifically, the gate of the external voltage NFET, the POR states and the pull-up states are refreshed.

Advantageously, the teachings of the disclosure provide for a linear voltage regulator with ultra low power consumption. The interdependency between the analog voltage regulator and the digital circuit is efficiently managed, while enabling the deactivation of one or more circuits and paths that consume the majority of the quiescent current between MEASUREMENT phases. Numerous applications will benefit from the ability to minimize power consumption without compromising measurement accuracy, speed and other ensuing benefits.

As will be appreciated, embodiments as disclosed include at least the method of claim 4.

Alternative embodiments of the method for voltage regulation are defined in method claims 5 to 11.

In another embodiment, a voltage regulator is a regulator according to claim 1.

Additional optional features of this voltage regulator are defined in claims 2 to 3.

Although the invention is described herein with reference to specific embodiments, various modifications and changes can be made without departing from the scope of the present invention as set forth in the claims below. Accordingly, the specification and figures are to be regarded in an illustrative rather than a restrictive sense. Any benefits, advantages, or solutions to problems that are described herein with regard to specific embodiments are not intended to be construed as a critical, required, or essential feature or element of any or all the claims.

Unless stated otherwise, terms such as "first" and "second" are used to arbitrarily distinguish between the elements such terms describe. Thus, these terms are not necessarily intended to indicate temporal or other prioritization of such elements.

## Claims

1. A voltage regulator, comprising:
a bandgap reference (12) enabled by a first digital signal (42) connected thereto,
the bandgap reference (12) configured to generate a reference voltage (38), and a bandgap status signal (40) indicating that the reference voltage (38) has stabilized;
a feedback loop (14) including an amplifier (44), a resistive divider (54-60), a fixed voltage reference (34), an internal voltage transistor (50), and an internal pull-up transistor (100),
the amplifier (44) enabled by the bandgap status signal (40) connected thereto, and configured to compare the reference voltage (38) with a feedback voltage (46) to generate a control voltage (48) on a gate of the internal voltage transistor (50), the internal voltage transistor (50) having a source follower configuration to generate an internal voltage (52) on a source terminal of the internal voltage transistor (50), the feedback voltage (46) generated by a resistive division of the internal voltage (52) by the resistive divider (54-60) connected between the source terminal of the internal voltage transistor (50) and a fixed voltage reference (34),
the internal pull-up transistor (100) connected in parallel with the internal voltage transistor (50);
an external voltage transistor (102) connected in parallel with an external pull-up transistor (106) and having the source follower configuration to generate an external voltage (104) on a source terminal of the external voltage transistor (102),
a gate of the external voltage transistor (102) connected to the gate of the internal voltage transistor (50); the external pull-up transistor (106);
a switch connected between the amplifier and the gate of the external voltage transistor (102);
a pull-up circuit (18) including a pull-up comparator (80) enabled by the bandgap status signal (40) connected thereto, and configured to compare a supply voltage (32) with the control voltage (48) increased by an offset voltage (82),
the pull-up comparator (80) connected to a gate of the internal pull-up transistor (100), and to a pull-up latch (88) connected between the pull-up comparator (80) and a gate of the external pull-up transistor (106);
a Power On Reset, POR,
circuit (22) including a POR comparator (122) enabled by the bandgap status signal (40) connected thereto, and configured to compare the reference voltage (38) with a scaled internal voltage (112) to generate an internal POR signal (124),
an external POR circuit (130) configured to generate an external POR signal (132) while the supply voltage (32) is less than a start-up threshold,
the internal POR signal (124) and the external POR signal (132) connected to an OR gate (134) to generate a POR signal (136); a POR latch (126) connected between the internal POR circuit and the OR gate (134); and
a digital circuit (20) connected to the source terminal of the external voltage transistor (102) to receive power,
the digital circuit (20) connected to the POR signal (136) configured to reset the digital circuit (20),
the digital circuit (20) configured to generate the first digital signal (42) and a second digital signal (92),
the first digital signal (42) connected to the bandgap reference (12),
the second digital signal (92) connected to the switch between the amplifier (44) and the gate of
the external voltage transistor (102), to the pull-up latch, and to the POR latch (126).

2. The voltage regulator of claim 1, wherein the amplifier (44) includes an input hysteresis formed by a gated connection between the amplifier (44) and one of two taps (62; 64) of the resistive divider (54-60) to generate the feedback voltage (46), one of the two taps (62; 64) selected in response to a high state of the pull-up comparator (80), and another of the two taps (62; 64) selected in response to a low state of the pull-up comparator (80).

3. The voltage regulator of claim 1 or claim 2, further comprising a sample-and-hold circuit including a switch (108) between the amplifier (44) and the gate of the external voltage transistor (102) to hold the control voltage (48) on a storage capacitance (110) of the external voltage transistor (102).

4. A method for operating a voltage regulator according to any preceding claim, the method comprising:
reducing a power consumption of the voltage regulator (30) during an IDLE phase, by disabling the feedback loop (14) configured to regulate the internal voltage (52) to a multiple of the reference voltage (38) in response to the voltage regulator (30) receiving the first digital signal (42) from the digital circuit (20),
the internal voltage (52) proportional to the external voltage (104) supplied to the digital circuit (20); and
increasing a regulated accuracy of the external voltage (104) during a MEASUREMENT phase by enabling the feedback loop (14) in response to the voltage
regulator (30) receiving the first digital signal (42) from the digital circuit (20), wherein the IDLE phase comprises:
storing a gate voltage (48) on the gate of the external voltage transistor (102), the external voltage (104) being less than the supply voltage (32);
latching a first state of the external pull-up transistor (106), the external pull-up transistor (106) changing the external voltage (104) to the supply voltage (32) in response to a difference between the supply voltage (32) and the gate voltage (48) being less than the offset voltage (82);
latching a second state of the internal Power On Reset, POR, signal (124); the internal POR signal (124) holding the digital circuit (20) in a reset state while the internal voltage (52) is less than the reference voltage (38), disabling the bandgap reference (12); and
disabling the feedback loop (14) in response to disabling the bandgap reference (12).

5. The method of claim 4, further comprising:
disabling a pull-up comparator (80) and a POR comparator (122) in response to disabling the bandgap reference (12),
the pull-up comparator (80) comparing the supply voltage (32) to the gate voltage (48) increased by the offset voltage (82), and
the POR comparator (122) comparing the internal voltage (52) to the reference voltage (38).

6. The method of claim 4 or claim 5, further comprising:
resetting the digital circuit (20) with an external POR (132) in response to the supply voltage (32) dropping below a start-up threshold.

7. The method of any one of the claims 4 to 6, further comprising:
determining by the digital circuit (20), an IDLE duration (186) of the IDLE phase and a MEASUREMENT duration (206) of the MEASUREMENT phase,
the voltage regulator (30) entering the MEASUREMENT phase at the end of the IDLE duration (186), and the voltage regulator (30) entering the IDLE phase at the end of the MEASUREMENT duration (206).

8. The method of any one of the claims 4 to 7,
wherein the MEASUREMENT phase comprises:
enabling the bandgap reference (12),
stabilizing the feedback loop (14) by ramping the internal voltage (52) in response to enabling the bandgap reference (12), and disabling the internal Power On Reset, POR, signal (124) in response to the internal voltage (52) exceeding the reference voltage (38), and
refreshing the gate voltage of the external voltage transistor (102) supplying the digital voltage to the digital circuit (20), by connecting the gate of the external voltage transistor (102) to the feedback loop (14), after a time delay following the disabling of the internal POR signal (124),
the time delay sufficient for the feedback loop (14) to stabilize.

9. The method of claim 8, further comprising:
updating a first state of the pull-up transistor (106),
the pull-up transistor (106) changing the external voltage (104) to the supply voltage (32) in response to a difference between the supply voltage (32) and the gate voltage (48) being less than an offset voltage (82), and
updating a second state of an internal Power On Reset, POR, signal (124),
the internal POR (124) holding the digital circuit (20) in a reset state while the internal voltage (52) is less than the reference voltage (38).

10. The method of any one of the claims 4 to 9, further comprising:
a START-UP phase before entering the IDLE phase, comprising:
ramping a supply voltage (32),
activating an external Power On Reset, POR, (132) while the supply voltage (32) is less than a start-up threshold,
the external POR (132) holding the digital circuit (20) in a reset state, activating a bandgap reference (12) in response to the first digital signal (42),
wherein the first digital signal (42) is an active-low signal, activating an internal Power On Reset, POR, signal (124) in response to the bandgap reference (12) providing the reference voltage (38),
the internal POR (124) activating before deactivating the external POR (132),
the internal POR (124) holding the digital circuit (20) in the reset state, and deactivating the internal POR (124) in response to the internal voltage (52) exceeding the reference voltage (38).

11. The method of claim 10, further comprising:
shifting a shifted voltage of the first digital signal (42) from the external voltage (104) to the supply voltage (32).

## Patentansprüche

1. Spannungsregler, umfassend:
eine Bandlückenreferenz (12), die durch ein erstes digitales Signal (42) freigegeben wird, das mit ihr verbunden ist,
die Bandlückenreferenz (12), die dazu ausgelegt ist, eine Referenzspannung (38) zu erzeugen, und ein Bandlückenstatussignal (40), das angibt, dass sich die Referenzspannung (38) stabilisiert hat;
eine Rückkopplungsschleife (14), die einen Verstärker (44), einen Widerstandsteiler (54-60), eine feste Spannungsreferenz (34), einen internen Spannungstransistor (50) und einen internen Pull-up-Transistor (100) beinhaltet,
den Verstärker (44), der durch das mit ihm verbundene Bandlückenstatussignal (40) freigegeben wird und dazu ausgelegt ist, die Referenzspannung (38) mit einer Rückkopplungsspannung (46) zu vergleichen, um eine Steuerspannung (48) an einem Gate des internen Spannungstransistors (50) zu erzeugen,
wobei der interne Spannungstransistor (50) eine Source-Folger-Konfiguration aufweist, um eine interne Spannung (52) an einem Source-Anschluss des internen Spannungstransistors (50) zu erzeugen,
die Rückkopplungsspannung (46), die durch die Widerstandsteilung der internen Spannung (52) durch den Widerstandsteiler (54-60) erzeugt wird, der zwischen dem Source-Anschluss des internen Spannungstransistors (50) und einer festen Spannungsreferenz (34) angeschlossen ist, den internen Pull-up-Transistor (100), der parallel zum internen Spannungstransistor (50) geschaltet ist;
einen externen Spannungstransistor (102), der parallel zu einem externen Pull-up-Transistor (106) geschaltet ist und die Source-Folger-Konfiguration aufweist, um eine externe Spannung (104) an einem Source-Anschluss des externen Spannungstransistors (102) zu erzeugen,
ein Gate des externen Spannungstransistors (102), das mit dem Gate des internen Spannungstransistors (50) verbunden ist;
den externe Pull-up-Transistor (106);
einen Schalter, der zwischen den Verstärker und das Gate des externen Spannungstransistors (102) geschaltet ist;
eine Pull-up-Schaltung (18), die einen Pull-up-Komparator (80) beinhaltet, der durch das damit verbundene Bandlückenstatussignal (40) freigegeben wird und dazu ausgelegt ist, eine Versorgungsspannung (32) mit der um eine Offsetspannung (82) erhöhten Steuerspannung (48) zu vergleichen,
den Pull-up-Komparator (80), der mit einem Gate des internen Pull-up-Transistors (100) verbunden ist, und mit einem Pull-up-Latch (88), der zwischen dem Pull-up-Komparator (80) und einem Gate des externen Pull-up-Transistors (106) angeschlossen ist;
eine Power-On Reset-, POR-, Schaltung (22), die einen POR-Komparator (122) beinhaltet, der durch das damit verbundene Bandlückenstatussignal (40) freigegeben wird, und dazu ausgelegt ist, die Referenzspannung (38) mit einer skalierten internen Spannung (112) zu vergleichen, um ein internes POR-Signal (124) zu erzeugen,
eine externe POR-Schaltung (130), die dazu ausgelegt ist, ein externes POR-Signal (132) zu erzeugen, während die Versorgungsspannung (32) geringer ist als ein Anlaufschwellenwert liegt,
das interne POR-Signal (124) und das externe POR-Signal (132), die mit einem ODER-Gatter (134) verbunden sind, um ein POR-Signal (136) zu erzeugen; einen POR-Latch (126), der zwischen der internen POR-Schaltung und dem ODER-Gatter (134) angeschlossen ist; und
eine digitale Schaltung (20), die mit dem Source-Anschluss des externen Spannungstransistors (102) verbunden ist, um Strom zu empfangen,
die digitale Schaltung (20), die mit dem POR-Signal (136) verbunden ist, das dazu ausgelegt ist, die digitale Schaltung (20) zurückzusetzen,
die digitale Schaltung (20), die dazu ausgelegt ist, das erste digitale Signal (42) und ein zweites digitales Signal (92) zu erzeugen,
das erste digitale Signal (42), das mit der Bandlückenreferenz (12) verbunden ist,
das zweite Digitalsignal (92), das mit dem Schalter zwischen dem Verstärker (44) und dem Gate des externen Spannungstransistors (102), mit dem Pull-up-Latch und mit dem POR-Latch (126) verbunden ist.

2. Spannungsregler nach Anspruch 1,
wobei der Verstärker (44) eine Eingangshysterese beinhaltet, die durch eine Gate-gesteuerte Verbindung zwischen dem Verstärker (44) und einem von zwei Abgriffen (62; 64) des Widerstandsteilers (54-60) gebildet wird, um die Rückkopplungsspannung (46) zu erzeugen, wobei einer der beiden Abgriffe (62; 64) als Reaktion auf einen hohen Zustand des Pull-Up-Komparators (80) ausgewählt wird und ein anderer der beiden Abgriffe (62; 64) als Reaktion auf einen niedrigen Zustand des Pull-Up-Komparators (80) ausgewählt wird.

3. Spannungsregler nach Anspruch 1 oder Anspruch 2, der ferner eine Abtast- und Halteschaltung umfasst, die einen Schalter (108) zwischen dem Verstärker (44) und dem Gate des externen Spannungstransistors (102) beinhaltet, um die Steuerspannung (48) an einer Speicherkapazität (110) des externen Spannungstransistors (102) zu halten.

4. Verfahren zum Betreiben eines Spannungsreglers nach einem der vorhergehenden Ansprüche, wobei das Verfahren umfasst:
Reduzieren einer Stromaufnahme des Spannungsreglers (30) während einer IDLE-Phase durch Blockieren der Rückkopplungsschleife (14), die dazu ausgelegt ist, die interne Spannung (52) auf ein Vielfaches der Referenzspannung (38) als Reaktion darauf zu regeln, dass der Spannungsregler (30) das erste digitale Signal (42) von der digitalen Schaltung (20) empfängt,
die interne Spannung (52), die proportional zur externen Spannung (104) ist, die die digitale Schaltung (20) versorgt; und
Erhöhen der Regelgenauigkeit der externen Spannung (104) während einer MESSUNG-Phase durch Freigeben der Rückkopplungsschleife (14) als Reaktion darauf, dass der Spannungsregler (30) das erste digitale Signal (42) von der digitalen Schaltung (20) empfängt,
wobei die IDLE-Phase umfasst:
Speichern einer Gate-Spannung (48) am Gate des externen Spannungstransistors (102),
wobei die externe Spannung (104) geringer ist als die Versorgungsspannung (32);
Festhalten eines ersten Zustands des externen Pull-up-Transistors (106),
wobei der externe Pull-up-Transistor (106) die externe Spannung (104) als Reaktion auf eine Differenz zwischen der Versorgungsspannung (32) und der Gate-Spannung (48), die geringer ist als die Offsetspannung (82), auf die Versorgungsspannung (32) verändert;
Festhalten eines zweiten Zustands des internen Power-On Reset-, POR-, Signals (124);
das interne POR-Signal (124), das die digitale Schaltung (20) in einem Rücksetzzustand hält, während die interne Spannung (52) geringer ist als die Referenzspannung (38), Blockieren der Bandlückenreferenz (12); und
Blockieren der Rückkopplungsschleife (14) als Reaktion auf das Blockieren der Bandlückenreferenz (12).

5. Verfahren nach Anspruch 4, ferner umfassend:
Blockieren eines Pull-up-Komparators (80) und eines POR-Komparators (122) als Reaktion auf das Blockieren der Bandlückenreferenz (12),
den Pull-up-Komparator (80), der die Versorgungsspannung (32) mit der um die Offsetspannung (82) erhöhten Gate-Spannung (48) vergleicht, und
den POR-Komparator (122), der die interne Spannung (52) mit der Referenzspannung (38) vergleicht.

6. Verfahren nach Anspruch 4 oder Anspruch 5, ferner umfassend:
Rücksetzen der digitalen Schaltung (20) mit einem externen POR (132) als Reaktion auf das Absinken der Versorgungsspannung (32) unter einen Anlaufschwellenwert.

7. Verfahren nach einem der Ansprüche 4 bis 6, ferner umfassend:
Bestimmen einer IDLE-Dauer (186) der IDLE-Phase und einer MESSUNG-Dauer (206) der MESSUNG-Phase durch die digitale Schaltung (20),
den Spannungsregler (30), der am Ende der IDLE-Dauer (186) in die MESSUNG-Phase eintritt, und den Spannungsregler (30), der am Ende der MESSUNG-Dauer (206) in die IDLE-Phase eintritt.

8. Verfahren nach einem der Ansprüche 4 bis 7,
wobei die MESSUNG-Phase umfasst:
Freigeben der Bandlückenreferenz (12),
Stabilisieren der Rückkopplungsschleife (14) durch Hochfahren der internen Spannung (52) als Reaktion auf das Freigeben der Bandlückenreferenz (12) und Blockieren des internen Power-On Reset-, POR-, Signals (124) als Reaktion darauf, dass die interne Spannung (52) die Referenzspannung (38) überschreitet, und
Auffrischen der Gate-Spannung des externen Spannungstransistors (102), der die digitale Schaltung (20) mit der digitalen Spannung versorgt, durch Verbinden des Gates des externen Spannungstransistors (102) mit der Rückkopplungsschleife (14), nach einer Zeitverzögerung,
die auf das Blockieren des internen POR-Signals (124) folgt,
die Zeitverzögerung, die ausreicht, um die Rückkopplungsschleife (14) zu stabilisieren.

9. Verfahren nach Anspruch 8, ferner umfassend:
Aktualisieren eines ersten Zustands des Pull-up-Transistors (106),
wobei der Pull-up-Transistor (106) die externe Spannung (104) als Reaktion auf eine Differenz zwischen der Versorgungsspannung (32) und der Gate-Spannung (48), die geringer ist als eine Offsetspannung (82), auf die Versorgungsspannung (32) verändert; und
Aktualisieren eines zweiten Zustands eines internen Power-On Reset-, POR-, Signals (124),
die interne POR (124), die die digitale Schaltung (20) in einem Rücksetzzustand hält, während die interne Spannung (52) geringer ist als die Referenzspannung (38).

10. Verfahren nach einem der Ansprüche 4 bis 9, ferner umfassend:
eine START-UP-Phase vor dem Eintritt in die IDLE-Phase, umfassend:
Hochfahren einer Versorgungsspannung (32),
Aktivieren eines externen Power-On Reset, POR, (132), während die Versorgungsspannung (32) geringer ist als ein Anlaufschwellenwert liegt,
der externe POR (132), der die digitale Schaltung (20) in einem Reset-Zustand hält,
Aktivieren einer Bandlückenreferenz (12) als Reaktion auf das erste digitale Signal (42), wobei das erste digitale Signal (42) ein Aktiv-Low-Signal ist,
Aktivieren eines internen Power-On Reset-, POR-, Signals (124) als Reaktion darauf, dass die Bandlückenreferenz (12) die Referenzspannung (38) bereitstellt,
den internen POR (124), der vor dem Deaktivieren des externen POR (132) aktiviert wird,
wobei der interne POR (124) die digitale Schaltung (20) im Rücksetzzustand hält und den internen POR (124) als Reaktion darauf deaktiviert, dass die interne Spannung (52) die Referenzspannung (38) überschreitet.

11. Verfahren nach Anspruch 10, ferner umfassend:
Verschieben einer verschobenen Spannung des ersten digitalen Signals (42) von der externen Spannung (104) auf die Versorgungsspannung (32).

## Revendications

1. Régulateur de tension comprenant :
une référence de bande interdite (12) activée par un premier signal numérique (42) qui lui est connecté, la référence de bande interdite (12) étant configurée pour générer une tension de référence (38), et un signal d'état de bande interdite (40) indiquant que la tension de référence (38) s'est stabilisée ;
une boucle de rétroaction (14) comprenant un amplificateur (44), un diviseur résistif (54-60), une référence de tension fixe (34), un transistor de tension interne (50) et un transistor d'excursion haute interne (100), l'amplificateur (44) étant activé par le signal d'état de bande interdite (40) qui lui est connecté, et
configuré pour comparer la tension de référence (38) à une tension de rétroaction (46) pour générer une tension de commande (48) sur une grille du transistor de tension interne (50), le transistor de tension interne (50) ayant une configuration de suiveur de source pour générer une tension interne (52) sur une borne de source du transistor de tension interne (50), la tension de rétroaction (46) étant générée par une division résistive de la tension interne (52) par le diviseur résistif (54-60) connecté entre la borne de source du transistor de tension interne (50) et une référence de tension fixe (34),
le transistor d'excursion haute interne (100) étant connecté en parallèle avec le transistor de tension interne (50) ;
un transistor de tension externe (102) connecté en parallèle avec un transistor d'excursion haute externe (106) et ayant une configuration de suiveur de source pour générer une tension externe (104) sur une borne de source du transistor de tension externe (102),
une grille du transistor de tension externe (102) connectée à la grille du transistor de tension interne (50) ;
le transistor d'excursion haute externe (106) ;
un commutateur connecté entre l'amplificateur et la grille du transistor de tension externe (102) ;
un circuit d'excursion haute (18) comprenant un comparateur d'excursion haute (80) activé par le signal d'état de bande interdite (40) qui lui est connecté, et
configuré pour comparer une tension d'alimentation (32) avec la tension de commande (48) augmentée d'une tension de décalage (82),
le comparateur d'excursion haute (80) connecté à une grille du transistor d'excursion haute interne (100) et à un verrou d'excursion haute (88) connecté entre le comparateur d'excursion haute (80) et une grille du transistor d'excursion haute externe (106) ;
un circuit (22) de réinitialisation à la mise sous tension, POR, comprenant un comparateur POR (122) activé par le signal d'état de bande interdite (40) qui lui est connecté, et configuré pour comparer la tension de référence (38) à une tension interne mise à l'échelle (112) pour générer un signal POR interne (124),
un circuit POR externe (130) configuré pour générer un signal POR externe (132) lorsque la tension d'alimentation (32) est inférieure à un seuil de démarrage,
le signal POR interne (124) et le signal POR externe (132) connectés à une porte OU (134) pour générer un signal POR (136) ;
un verrou POR (126) connecté entre le circuit POR interne et la porte OU (134) ; et
un circuit numérique (20) connecté à la borne de source du transistor de tension externe (102) pour recevoir de l'énergie,
le circuit numérique (20) connecté au signal POR (136) configuré pour réinitialiser le circuit numérique (20), le circuit numérique (20) configuré pour générer le premier signal numérique (42) et un second signal numérique (92),
le premier signal numérique (42) connecté à la référence de bande interdite (12),
le second signal numérique (92) connecté au commutateur entre l'amplificateur (44) et la grille du transistor de tension externe (102), au verrou d'excursion haute et au verrou POR (126).

2. Régulateur de tension selon la revendication 1, dans lequel l'amplificateur (44) comprend une hystérésis d'entrée formée par une connexion à porte entre l'amplificateur (44) et l'une de deux prises (62 ; 64) du diviseur résistif (54-60) pour générer la tension de rétroaction (46), l'une des deux prises (62 ; 64) étant sélectionnée en réponse à un état haut du comparateur d'excursion haute (80), et une autre des deux prises (62 ; 64) étant sélectionnée en réponse à un état bas du comparateur d'excursion haute (80).

3. Régulateur de tension selon la revendication 1 ou la revendication 2, comprenant en outre un circuit d'échantillonnage et de maintien comprenant un commutateur (108) entre l'amplificateur (44) et la grille du transistor de tension externe (102) pour maintenir la tension de commande (48) sur une capacité de stockage (110) du transistor de tension externe (102).

4. Procédé de fonctionnement d'un régulateur de tension selon l'une quelconque des revendications précédentes, le procédé comprenant les étapes suivantes :
réduire la consommation d'énergie du régulateur de tension (30) durant une phase de repos, IDLE, en désactivant la boucle de rétroaction (14) configurée pour réguler la tension interne (52) à un multiple de la tension de référence (38) en réponse à la réception par le régulateur de tension (30) du premier signal numérique (42) provenant du circuit numérique (20),
la tension interne (52) étant proportionnelle à la tension externe (104) fournie au circuit numérique (20) ; et
augmenter la précision régulée de la tension externe (104) durant une phase de mesure, MEASUREMENT, en activant la boucle de rétroaction (14) en réponse à la réception, par le régulateur de tension (30), du premier signal numérique (42) provenant du circuit numérique (20),
où la phase de repos, IDLE, comprend les étapes suivantes :
stocker une tension de grille (48) sur la grille du transistor de tension externe (102), la tension externe (104) étant inférieure à la tension d'alimentation (32) ;
verrouiller un premier état du transistor d'excursion haute externe (106), le transistor d'excursion haute externe (106) faisant passer la tension externe (104) à la tension d'alimentation (32) en réponse à une différence entre la tension d'alimentation (32) et la tension de grille (48) étant inférieure à la tension de décalage (82) ;
verrouiller un second état du signal interne de réinitialisation à la mise sous tension, POR, (124) ;
le signal POR interne (124) maintenant le circuit numérique (20) dans un état de réinitialisation tandis que la tension interne (52) est inférieure à la tension de référence (38),
désactiver la référence de bande interdite (12) ; et
désactiver la boucle de rétroaction (14) en réponse à la désactivation de la référence de bande interdite (12).

5. Procédé selon la revendication 4, comprenant en outre :
la désactivation d'un comparateur d'excursion haute (80) et d'un comparateur POR (122) en réponse à la désactivation de la référence de bande interdite (12),
le comparateur d'excursion haute (80) comparant la tension d'alimentation (32) à la tension de grille (48) augmentée de la tension de décalage (82), et
le comparateur POR (122) comparant la tension interne (52) à la tension de référence (38).

6. Procédé selon la revendication 4 ou la revendication 5, comprenant en outre :
la réinitialisation du circuit numérique (20) avec une POR externe (132) en réponse à la chute de la tension d'alimentation (32) en dessous d'un seuil de démarrage.

7. Procédé selon l'une quelconque des revendications 4 à 6, comprenant en outre :
la détermination, par le circuit numérique (20), d'une durée de repos, IDLE, (186) de la phase de repos, IDLE, et d'une durée de mesure, MEASUREMENT, (206) de la phase de mesure, MEASUREMENT,
le régulateur de tension (30) entrant dans la phase de mesure, MEASUREMENT, à la fin de la durée de repos, IDLE, (186), et le régulateur de tension (30) entrant dans la phase de repos, IDLE, à la fin de la durée de mesure, MEASUREMENT (206).

8. Procédé selon l'une quelconque des revendications 4 à 7, dans lequel la phase de mesure, MEASUREMENT, comprend :
l'activation de la référence de bande interdite (12), la stabilisation de la boucle de rétroaction (14) en augmentant linéairement la tension interne (52) en réponse à l'activation de la référence de bande interdite (12), et la désactivation du signal interne de réinitialisation à la mise sous tension, POR, (124) en réponse à la tension interne (52) dépassant la tension de référence (38), et
le rafraîchissement de la tension de grille du transistor de tension externe (102) fournissant la tension numérique au circuit numérique (20), en connectant la grille du transistor de tension externe (102) à la boucle de rétroaction (14), après un délai qui suit la désactivation du signal POR interne (124),
le délai étant suffisant pour que la boucle de rétroaction (14) se stabilise.

9. Procédé selon la revendication 8, comprenant en outre :
la mise à jour d'un premier état du transistor d'excursion haute (106),
le transistor d'excursion haute (106) faisant passer la tension externe (104) à la tension d'alimentation (32) en réponse à une différence entre la tension d'alimentation (32) et la tension de grille (48) étant inférieure à une tension de décalage (82), et
la mise à jour d'un second état d'un signal interne de réinitialisation à la mise sous tension, POR, (124),
le signal POR interne (124) maintenant le circuit numérique (20) dans un état de réinitialisation tandis que la tension interne (52) est inférieure à la tension de référence (38).

10. Procédé selon l'une quelconque des revendications 4 à 9, comprenant en outre :
une phase de démarrage, START-UP, avant d'entrer dans la phase de repos, IDLE, comprenant :
l'augmentation linéaire d'une tension d'alimentation (32),
l'activation d'une réinitialisation à la mise sous tension, POR, externe (132) tandis que la tension d'alimentation (32) est inférieure à un seuil de démarrage,
la POR externe (132) maintenant le circuit numérique (20) dans un état de réinitialisation,
l'activation d'une référence de bande interdite (12) en réponse au premier signal numérique (42), où le premier signal numérique (42) est un signal actif-bas,
l'activation d'un signal de réinitialisation à la mise sous tension, POR, interne (124) en réponse à la référence de bande interdite (12) fournissant la tension de référence (38),
la POR interne (124) s'activant avant la désactivation de la POR externe (132),
la POR interne (124) maintenant le circuit numérique (20) dans l'état de réinitialisation, et
la désactivation de la POR interne (124) en réponse à la tension interne (52) dépassant la tension de référence (38) .

11. Procédé selon la revendication 10, comprenant en outre :
le décalage d'une tension décalée du premier signal numérique (42) de la tension externe (104) à la tension d'alimentation (32).
